# EUROPÄISCHE PATENTSCHRIFT

(11) **EP 1 199 913 B1**
(45) Veröffentlichungstag und Bekanntmachung des Hinweises auf die Patenterteilung: **04.05.2005**
(21) Anmeldenummer: 01124318.5
(22) Anmeldetag: 19.10.2001
(51) Int. Cl.: H05K 1/02, H05K 7/02

(54) **Verfahren zur Herstellung von Leiterfolie-Trägergehäuse-Einheiten**
Method for making units comprising a circuit foil and a carrier housing
Méthode de fabrication d'unités comprenant une feuille de circuit et un boîtier de support

(30) Priorität: 19.10.2000 DE 10051884
(43) Veröffentlichungstag der Anmeldung: 24.04.2002
(73) Patentinhaber: Cherry GmbH, 91275 Auerbach (DE)
(72) Erfinder: Michel, Kurt, 91257 Pegnitz (DE); Ehmann, Stefan, 90411 Nürnberg (DE); Friedl, Roland, 91275 Auerbach (DE); Bauer, Günter, 92237 Sulzberg-Rosenberg (DE)
(74) Vertreter: Frohwitter, Bernhard, Dipl.-Ing.

(56) Entgegenhaltungen:
- EP-A- 0 386 279
- EP-A- 0 784 418
- DE-A- 1 766 729
- DE-A- 2 734 994
- DE-A- 4 436 523
- DE-A- 19 720 106
- US-A- 5 669 775
- US-A- 6 059 382
- PATENT ABSTRACTS OF JAPAN vol. 1996, no. 01, 31. Januar 1996 (1996-01-31) & JP 07 235782 A (THK MENT KENKYUSHO:KK), 5. September 1995 (1995-09-05)

## Beschreibung

Die Erfindung betrifft ein Verfahren zur Herstellung einer Leiterfolie-Trägergehäuse-Einheit aus einer elektrische Leiterbahnen aufweisenden flexiblen Leiterfolie, mindestens einem elektrischen Bauelement, mindestens einem elektrischen Kontaktelement, mindestens einem Bauelemente-Nest und einem Trägergehäuse.

Nach Verfahren der hier angesprochenen Art hergestellte Leiterfolie-Trägergehäuse-Einheiten sind bekannt. Sie setzen sich aus einer Leiterfolie und einem Trägergehäuse zusammen. Die als Widerstände, Kondensatoren, Spulen, Transistoren oder dergleichen ausgebildeten elektrischen Bauelemente und die als mechanische, elektrische oder magnetische Schalter, Kontaktstifte oder dergleichen ausgebildeten elektrischen Kontaktelemente sind auf der Leiterfolie angeordnet und mit den Leiterbahnen derselben elektrisch verbunden. Manche der elektrischen Bauelemente sind zum Schutz vor schädlichen äußeren Einflüssen wie Feuchtigkeit und Temperaturschwankungen teilweise oder gänzlich in Bauelemente-Nester eingebettet. Die Bauelemente-Nester sind als auf der Leiterfolie ausgebildete und die Bauelemente umhüllende Spritzguß-Nester ausgebildet. Die die Bauelemente, die Kontaktelemente und die Bauelemente-Nester aufweisende Leiterfolie ist schließlich zum Zwecke der besseren Handhabbarkeit der Leiterfolie-Trägergehäuse-Einheit und zum Schutz vor schädlichen äußeren Einflüssen, insbesondere vor mechanischen Beaufschlagungen, in einem Trägergehäuse untergebracht.

Verfahren der hier angesprochenen Art zur Herstellung einer Leiterfolie-Trägergehäuse-Einheit sind aus dem Stand der Technik bekannt.

So zeigt die deutsche Offenlegungsschrift DE 44 36 523 A1 ein Verfahren zur Herstellung einer Leiterfolie-Trägergehäuse-Einheit, bei dem zunächst eine mit elektrischen Baulementen und Kontaktelementen bestückte Leiterfolie in einem ersten Verfahrensschritt derart teilweise mit einer Spritzgußmasse umspritzt wird, daß den Bauelemente-Nestern entsprechende Aussparungen im Bereich der Baulemente und Kontaktelemente verbleiben, bei dem sodann in einem zweiten Verfahrensschritt die Leiterfolie durch die Aussparungen hindurch bestückt wird, und bei dem schließlich in einem dritten Verfahrensschritt die teilweise umspritzte Leiterfolie erneut mit der Spritzgußmasse umspritzt wird, so daß das Trägergehäuse entsteht.

Die deutsche Offenlegungsschrift DE 199 40 339 A1 wiederum offenbart ein Verfahren zur Herstellung einer Leiterfolie-Trägergehäuse-Einheit, bei dem die Leiterfolie in einem Gußwerkzeug mit einer Spritzgußmasse umspritzt wird, so daß ein Trägergehäuse in Form eines gitter- beziehungsweise neztstrukturartigen Kunststoffinantels erzeugt wird.

Den Verfahren der beiden aufgeführten Druckschriften ist gemeinsam, daß es bei den nach ihnen hergestellten Leiterfolie-Trägergehäuse-Einheiten nicht möglich ist, die Leiterfolie oder das elektrische Bauelement auszutauschen, was beispielsweise im Falle eines Defektes der Leiterfolie oder des Bauelementes von Nöten ist.

Es ist daher Aufgabe der Erfindung, ein Verfahren zur Herstellung von Leiterfolie-Trägergehäuse-Einheiten anzugeben, bei dem in der verfahrensgemäß hergestellten Leiterfolie-Trägergehäuse-Einheit ein Austausch der Leiterfolie und/oder des elektrischen Bauelementes möglich ist.

Die Aufgabe wird erfindungsgemäß durch ein erstes Verfahren der hier angesprochenen Art gelöst, daß durch die nachstehenden Schritte gekennzeichnet ist: [1a] mechanisches und elektrisches Verbinden der Leiterfolie mit dem elektrischen Bauelement und dem elektrischen Kontaktelement, [1b] Herstellen mindestens eines offenen Bauelemente-Nestes um mindestens eines der elektrischen Bauelemente herum durch Spritzen oder Ausgießen, [1c] Verschließen der offenen Bauelemente-Nester durch Spritzen oder Ausgießen und [1d] mechanisches Verbinden der verschlossenen Bauelemente-Nester mit dem Trägergehäuse. Im Gegensatz zu den Verfahren des Standes der Technik sieht das erste Verfahren als letzten Verfahrensschritt ein mechanisches Verbinden der Leiterfolie und der verschlossenen Bauelement-Nestern mit dem Trägergehäuse vor, wobei mit mechanischem Verbinden das Herstellen einer formschlüssigen Verbindung zwischen der Leiterfolie und dem Trägergehäuse zu verstehen ist. Die Art der Verbindung zwischen der Leiterfolie und dem Trägergehäuse läßt einen schnellen Austausch der Leiterfolie und/oder des elektrischen Bauelementes zu.

Die elektrischen Bauelemente und Kontaktelemente können in dem Schritt [1a] auf verschiedene Weisen mit der Leiterfolie verbunden werden. Gängig ist hier ein Löten oder Schweißen (Laserverschweißen).

Das Verschließen der Bauelemente-Nester in dem Schritt [1c] kann derart erfolgen, daß die in den Bauelemente-Nestern enthaltenen Bauelemente vollkommen von Spritzguß umgeben sind. Dann ist das Bauelement vollständig eingekapselt und daher bestens vor schädlichen äußeren Einflüssen geschützt. Das Verschließen der Bauelemente-Nester in dem Schritt [1c] kann zudem derart erfolgen, daß die in den Bauelemente-Nestern enthaltenen Bauelemente lediglich teilweise von Spritzguß umgeben sind. Dies ist beispielsweise dann vorteilhaft, wenn das Bauelement Anschlußbereiche aufweist, an die später weitere elektrische Bauelemente angeschlossen werden sollen oder wenn das Bauelement zu einem späteren Zeitpunkt noch zu trimmen ist. In diesem Fall können auch in einem nach dem Schritt [1d] erfolgenden weiteren Schritt die Bauelemente-Nester noch vollkommen ausgegossen werden.

Die Aufgabe wird darüber hinaus auch durch ein zweites Verfahren der hier angesprochenen Art gelöst, daß durch die nachstehenden Schritte gekennzeichnet ist: [2a] Herstellen des Bauelemente-Nestes, [2b] Herstellen des Trägergehäuses durch ein Umspritzen oder Ausgießen des Kontaktelementes und [2c] mechanisches und elektrisches Verbinden der Leiterfolie, des Bauelemente-Nestes und des Trägergehäuses. Auch dieses erfindungsgemäße Verfahren hebt sich dadurch vom Stand der Technik ab, daß als letzter Verfahrensschritt ein mechanisches Verbinden der Leiterfolie und des Trägergehäuses vorgesehen ist. Entsprechend den bereits getätigten Ausführungen läßt auch das zweite Verfahren einen schnellen Austausch der Leiterfolie und/oder des elektrischen Bauelementes zu.

Schließlich wird die Aufgabe auch durch ein drittes Verfahren der hier angesprochenen Art gelöst, daß durch die nachstehenden Schritte gekennzeichnet ist: [3a] Herstellen der Bauelemente-Nester, [3b] Herstellen des Trägergehäuses durch Hinterspritzen oder Ausgießen der Leiterfolie und [3c] mechanisches und elektrisches Verbinden des Trägergehäuses, des Kontaktelementes und der Bauelemente-Nester. Wie bei den beiden bisher geschilderten Verfahren ist auch hier im letzten Verfahrensschritt ein mechanisches Verbinden vorgesehen, wodurch auch hier ein schneller Austausch der Leiterfolie und/oder des elektrischen Bauelementes möglich wird.

Besonders bevorzugt bei der Herstellung der Bauelemente-Nester in dem Schritt [2a] oder [3a] ist ein Verfahren, das die nachstehenden Schritte umfaßt: [A] Herstellen eines eine Vielzahl von formgleichen Abschnitten aufweisenden Stanzgitters durch Stanzen eines aus einem elektrisch leitenden Material bestehenden Bogens oder Bereitstellen einer Leiterplatte mit einer Vielzahl von formgleichen Abschnitten, [B] Herstellen offener Bauelemente-Nester durch Umspritzen oder Ausgießen jedes der formgleichen Abschnitte, [C] mechanisches und elektrisches Verbinden der offenen Bauelemente-Nester mit den elektrischen Bauelementen durch Löten oder Verschweißen (Laserverschweißen) der Bauelemente in die Bauelemente-Nester derart, daß die elektrischen Bauelemente mit dem Stanzgitter oder der Leiterplatte elektrisch leitend verbunden sind, [D] Verschließen der Bauelemente-Nester durch Ausspritzen oder Ausgießen der Bauelemente-Nester, [E] Vereinzeln der Bauelemente-Nester durch Zertrennen des Stanzgitters oder der Leiterplatte. Mit Hilfe dieses Verfahrens können eine große Anzahl von Bauelemente-Nestern schnell und einfach hergestellt werden.

Das mechanische und elektrische Verbinden in dem Schritt [2c] oder [3c] kann auf verschiedene Weisen realisiert werden. So können die Leiterfolie im Bereich der Leiterbahnen Öffnungen und die Bauelemente-Nester den Öffnungen anzahl- und anordnungsmäßig zugeordnete stiftartige Stanzgitteranschlüsse aufweisen. Hier entspricht das mechanische und elektrische Verbinden in dem Schritt [2c] oder [3c] einem Einführen der Stanzgitteranschlüsse in die Öffnungen, einem Inberührungbringen der Stanzgitteranschlüsse mit den Leiterbahnen und gegebenfalls einem Verlöten oder Verschweißen (Laserverschweißen) der Stanzgitteranschlüsse mit den Leiterbahnen.

Das mechanische Verbinden in dem Schritt [1d], [2c] oder [3c] kann auf verschiedene Weisen realisiert werden. So kann das Trägergehäuse eine Ausnehmung aufweisen, deren Querschnittsform der Form der Leiterfolie entspricht. Das mechanische Verbinden in dem Schritt [1d], [2c] oder [3c] entspricht in diesem Fall einem Einlegen der Leiterfolie in die Ausnehmung. Alternativ oder kumulativ hierzu können das Trägerhäuse Verbindungsvorsprünge und die Leiterfolie den Verbindungsvorsprüngen anzahl- und anordnungsmäßig zugeordnete Verbindungsöffnungen aufweisen. Das mechanische Verbinden in dem Schritt [1d], [2c] oder [3c] ist dann ein Einführen der Verbindungsvorsprünge in die jeweils zugeordneten Verbindungsöffnungen und ein anschließendes Verstemmen der Verbindungsvorsprünge. Alternativ oder kumulativ hierzu können das Trägergehäuse mit Aufhahmenuten versehene Verbindungstaschen und die Bauelemente-Nester den Aufnahmenuten anzahl- und anordnungsmäßig zugeordnete Eingriffskanten aufweisen. In diesem Fall ist das mechanische Verbinden in dem Schritt [1d], [2c] oder [3c] ein Einführen der Eingriffskanten in die Aufhahmenuten bis zu einer vollständigen Aufnahme der Bauelemente-Nester in den Verbindungstaschen.

Bei einer bevorzugten Ausführungsvariante des Verfahrens ist vorgesehen, daß die Leiterbahnen der Leiterfolie aus Kupfer gefertigt sind.

Schließlich ist auch bevorzugt vorgesehen, wenn die Bauelemente-Nester und das Trägergehäuse aus Kunststoff bestehen.

Weitere Ausführungsvarianten der erfindungsgemäßen Verfahren sowie deren Vorteile ergeben sich aus der nachfolgenden Zeichnung. In dieser zeigen
- Figur 1: eine Leiterfolie nach einem Schritt [1a] eines ersten Verfahrens,
- Figur 2: einen Ausschnitt aus einer anderen Leiterfolie nach einem Schritt [1b] des ersten Verfahrens,
- Figur 3: den Auschnitt aus der Leiterfolie gemäß Figur 2 nach einem Schritt [1c] des ersten Verfahrens,
- Figur 4: eine Leiterfolie-Trägergehäuse-Einheit nach einem Schritt [1d] des ersten Verfahrens,
- Figur 5: einen Ausschnitt aus der Leiterfolie-Trägergehäuse-Einheit gemäß Figur 4 in vergrößerter Darstellung,
- Figur 6: ein Stanzgitter vor der Herstellung einer Mehrzahl von Bauelemente-Nestern gemäß dem Schritt [2a] eines zweiten Verfahrens,
- Figur 7: die Mehrzahl von Bauelemente-Nestern gemäß dem Schritt [2a] des zweiten Verfahrens,
- Figur 8: ein Bauelemente-Nest gemäß dem Schritt [2a] des zweiten Verfahrens,
- Figur 9: ein Trägergehäuse nach einem Schritt [2b] des erfindungsgemäßen zweiten Verfahrens,
- Figur 10: einen Ausschnitt aus einer Leiterfolie-Trägergehäuse-Einheit nach einem Schritt [2c] des zweiten Verfahrens,
- Figur 11: eine Leiterfolie-Trägergehäuse-Einheit nach einem Schritt [3b] eines dritten Verfahrens in einer ersten Ansicht und
- Figur 12: die Leiterfolie-Trägergehäuse-Einheit der Figur 11 nach einem Schritt [3c] des dritten Verfahrens in einer zweiten Ansicht.

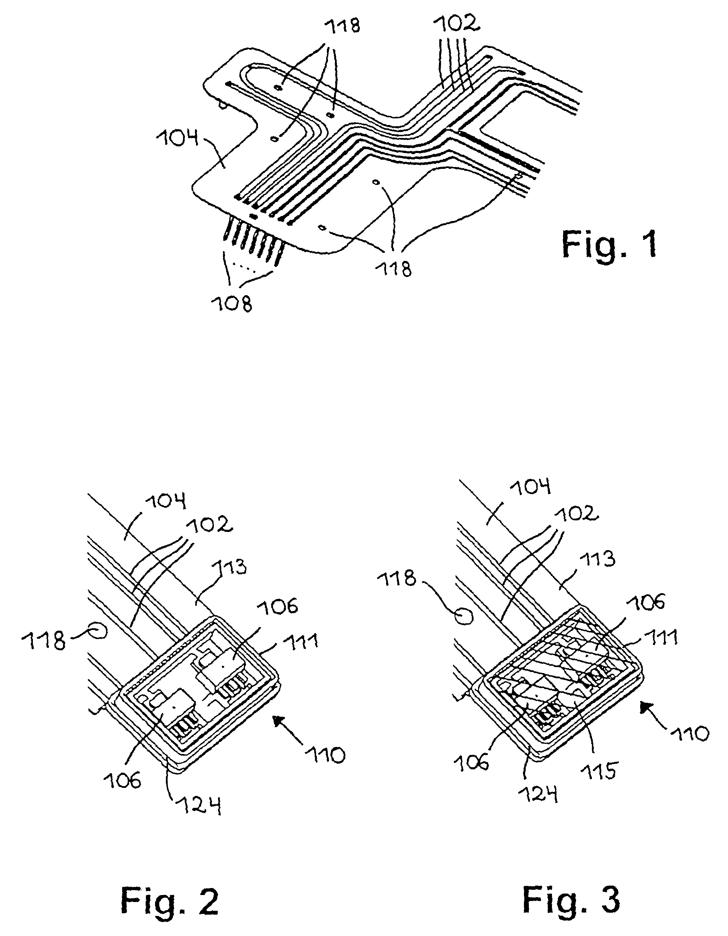

Die Figuren 1 bis 5 illustrieren das erste Verfahren.

Figur 1 zeigt eine flexible Leiterfolie 104. Die Leiterfolie 104 besteht teilweise aus Polyimid. Sie kann jedoch auch aus einem anderen Flexibilität bewirkenden Material wie beispielsweise Polyester oder dergleichen bestehen. Die Leiterfolie 104 weist eine Vielzahl elektrischer Leiterbahnen 102 auf. Die elektrischen Leiterbahnen 102 sind gemäß einem bestimmten Layout an der Oberfläche der Leiterfolie 104 angeordnet. Sie bestehen aus Kupfer und sind mittels gängiger Verfahren wie beispielsweise Ätzen auf die Oberfläche der Leiterfolie 104 aufgebracht. An der Oberfläche der Leiterfolie 104 sind zudem eine Mehrzahl elektrischer Kontaktelemente 108 angeordnet. Die Kontaktelemente 108 sind jeweils mit den Leiterbahnen 102 verlötet und mit diesen elektrisch leitend verbunden. Die flexible Leiterfolie 104 weist schließlich auch eine Mehrzahl von Verbindungsöffnungen 118 auf, deren Wirkung nachstehend noch erläutert wird. Die Verbindungsöffnungen 118 sind als die flexible Leiterfolie 104 durchsetzende Löcher ausgebildet.

Die Figur 1 zeigt die flexible Leiterfolie 104 nach Ausführung des Schrittes [1a] des erfindungsgemäßen ersten Verfahrens. In diesem Zustand sind die Leiterfolie 104 und die Kontaktelemente 108 miteinander mechanisch und elektrisch verbunden.

In der Figur 2 ist eine anderes Teil der elektrischen Leiterfolie 104 dargestellt. Die Leiterfolie 104 ist mit zwei elektrischen Bauelementen 106 bestückt. Die elektrischen Baulemente 106 sind an die elektrischen Leiterbahnen 102 gelötet und somit mechanisch und elektrisch mit diesen verbunden. Im Ausführungsbeispiel der Figur 2 sind die beiden Bauelemente 106 identisch ausgebildet und parallel nebeneinander liegend in einer kompakten Baueinheit zusammengefaßt. Die beiden Bauelemente 106 sind innerhalb eines Baulemente-Nestes 110 angeordnet. Das Bauelemente-Nest 110 umfaßt eine umlaufende Wandung 111, deren oberes Ende die beiden Baulemente 106 leicht überragt. An deren unterem, der Leiterfolie zugewandten Ende ist eine Eingriffskante 124 in Form eines umlaufenden Vorsprunges ausgebildet. Das Bauelemente-Nest 110 wird im Spritzgußverfahren hergestellt. Im Ausführungsbeispiel der Figur 2 ist das Bauelemente-Nest 110 an einem auslaufenden Ende 113 der Leiterfolie 104 angeordnet.

Die Leiterfolie 104 befindet sich in Figur 2 im Zustand nach Ausführung des Schrittes [1b] des erfindungsgemäßen ersten Verfahrens, das heißt, um die beiden elektrischen Bauelemente 106 herum ist das (noch nicht verschlossene) Bauelemente-Nest 110 angeordnet.

Die Leiterfolie 104 gemäß Figur 3 entspricht im wesentlichen derjenigen in Figur 2. Sie befindet sich jetzt allerdings im Zustand nach Ausführung des Schrittes [1c] des erfindungsgemäßen ersten Verfahrens, daß heißt, das Bauelemente-Nest 110 ist jetzt mittels einer durch Schraffur angedeuteten Spritzgußmasse 115 verschlossen.

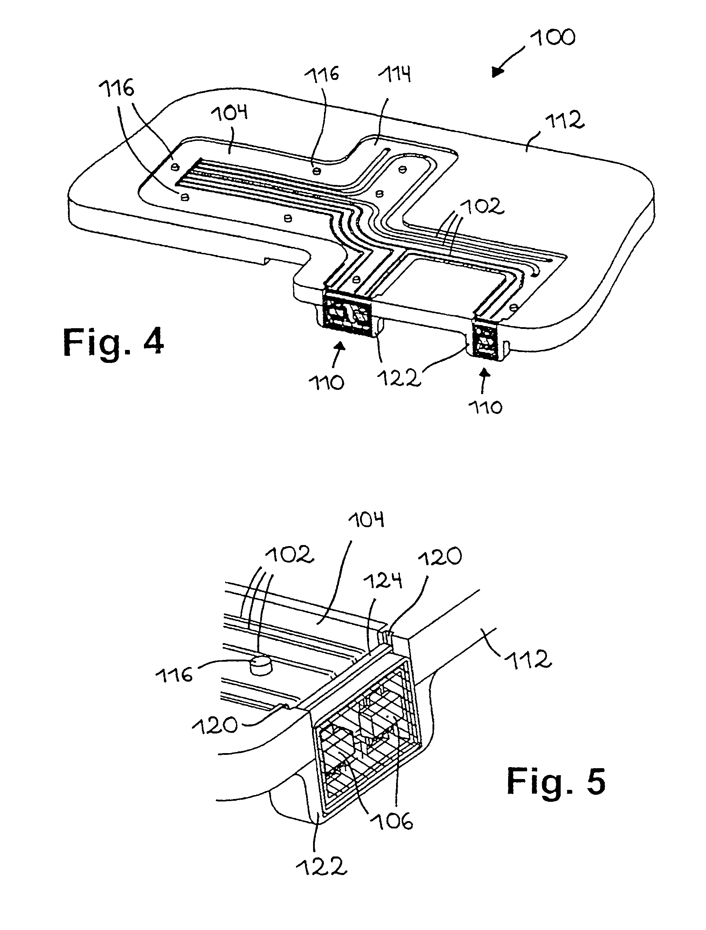

Figur 4 zeigt die in ein Trägergehäuse 112 eingebrachte Leiterfolie 104. Die Leiterfolie 104 ist in einer Ausnehmung 114 des Trägergehäuses 112 untergebracht und liegt flächig am Boden der Ausnehmung 114 an. Das Trägergehäuse 112 und die Leiterfolie 104 bilden so zusammen die Leiterfolie-Trägergehäuse-Einheit 100.

Die Verbindung der Leiterfolie 104 und des Trägergehäuses 112 ist durch mehrere mechanische Mittel bewirkt.

So weist das Trägergehäuse 112 eine Mehrzahl von sich von dem Boden der Ausnehmung 114 wegerstreckenden Verbindungsvorsprüngen 116 auf. Die Verbindungsvorsprünge 116 sind den Verbindungsöffnungen 118 der Leiterfolie 104 anzahl- und anordnungsmäßig zugeordnet und durchgreifen diese. Die Verbindungsvorsprünge sind verstemmt, das heißt, deren von dem Boden der Ausnehmung 114 wegweisende Enden sind verdickt, so daß die Verbindungsvorsprünge 116 des Trägergehäuses 112 nicht aus den Verbindungsöffnungen 118 der Leiterfolie 104 gleiten können.

Als weiteres mechanisches Mittel zur Herstellung einer Verbindung zwischen der Leiterfolie 104 und dem Trägergehäuse 112 weist das Trägergehäuse 112 zwei Verbindungstaschen 122 auf. Im Ausführungsbeispiel der Figur 4 sind die Verbindungstaschen 122 am Rand des Trägergehäuses 112 angeordnet und erstrecken sich in einer senkrecht zur Erstreckungsebene des Trägergehäuses 112 verlaufenden Ebene. Sie weisen jeweils die Form eines in etwa quaderförmigen Hohlraumes auf.

Wie in Figur 5 dargestellt, sind die Verbindungstaschen 122 an zwei gegenüberliegenden Seiten jeweils mit einer Aufnahmenut 120 versehen. Die Aufnahmenuten 120 sind jeweils so bemessen, daß sie die Eingriffskanten 124 der Bauelemente-Nester 110 klemmend halten können, das heißt, zwischen den Eingriffskanten 124 und den Aufnahmenuten 120 bildet sich ein Reibschluß aus.

Die Leiterfolie-Trägergehäuse-Einheit 100 gemäß Figuren 4 und 5 befindet sich im Zustand nach Ausführung des Schrittes [1d] des erfindungsgemäßen ersten Verfahrens. In diesem Zustand sind die geschlossenen Bauelemente-Nester 110 und das Trägergehäuse 112 mechanisch miteinander verbunden.

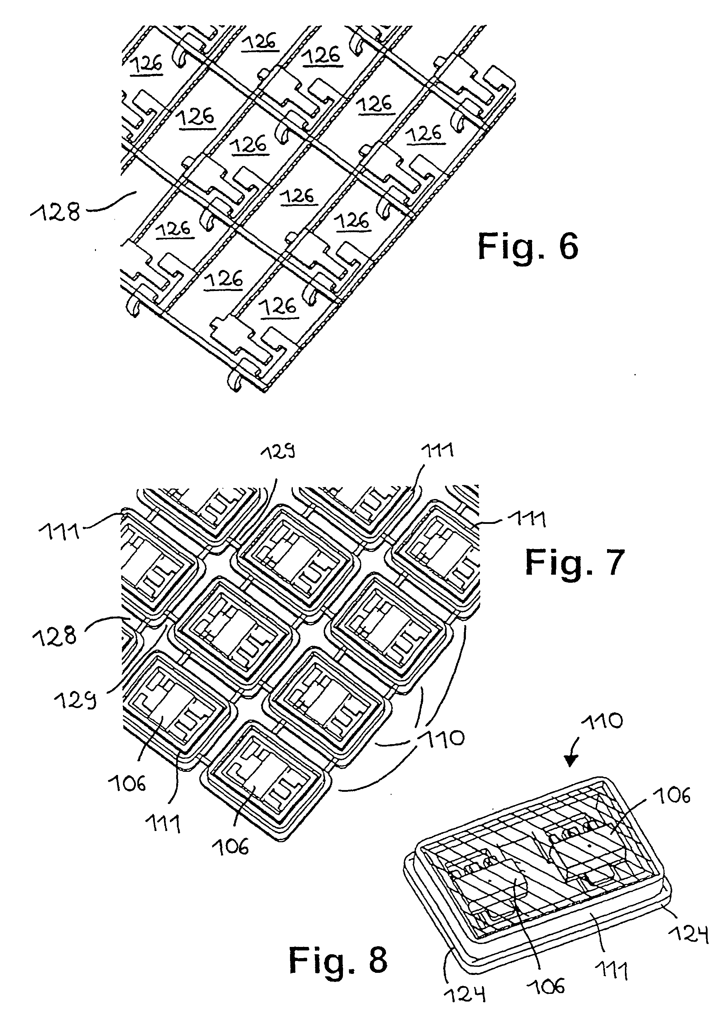

Die Figuren 6 bis 10 verbildlichen das zweite Verfahren. Hierbei zeigen die Figuren 6 bis 8 zunächst die Herstellung eines Mehrzahl von Bauelemente-Nestern 110 gemäß dem Schritt [2a] des erfindungsgemäßen zweiten Verfahrens.

Ausgangspunkt für die Herstellung der Bauelemente-Nester 110 ist das in Figur 6 dargestellte Stanzgitter 128. Das Stanzgitter 128 besteht aus einem elektrisch leitenden Material und wird durch Stanzen eines Bogens hergestellt. Es weist eine Vielzahl formgleicher Abschnitte 126 auf. Die formgleichen Abschnitte 126 sind in einer regelmäßigen Gitterstruktur angeordnet und bauen so das Stanzgitter 128 auf. Das Stanzgitter 128 gemäß Figur 6 stellt den Zustand nach Ausführung des Schrittes [A] dar.

In Figur 7 ist um jeden der formgleichen Abschnitte 126 des Stanzgitters 128 eine umlaufende Wandung 111 angeordnet. Die Wandung 111 wird durch Umspritzen der formgleichen Abschnitte 126 hergestellt und erstreckt sich in einer senkrecht zur Erstreckungsebene des Stanzgitters 128 verlaufenden Ebene. Sie faßt einen in etwa quaderförmigen Hohlraum in ihrem Inneren ein. Im Inneren dieses Hohlraumes ist jeweils ein elektrisches Bauelement 106 angeordnet. Das elektrische Bauelement 106 ist auf dem Stanzgitter 128 aufgelötet und elektrisch leitend mit diesem verbunden. Jeder formgleiche Abschnitt 126 des Stanzgitters 128 bildet zusammen mit dem ihm zugeordneten elektrischen Bauelement 106 und der umlaufenden Wandung 111 ein Bauelemente-Nest 110.

In Figur 7 sind die Bauelemente-Nester 110 nach Ausführung der beiden Schritte [B] und [C] dargestellt.

Das fertige Bauelemente-Nest 110 ist schließlich in Figur 8 dargestellt. Hier sind auch die beiden Schritte [D] und [E] ausgeführt, das heißt, jedes Bauelemente-Nest 110 wurde mittels einer durch Schraffur dargestellten Spritzgußmasse verschlossen, und die Bauelemente-Nester 110 wurden mittels Durchtrennen von Durchtrennungsstellen 129 des Stanzgitters 128 vereinzelt.

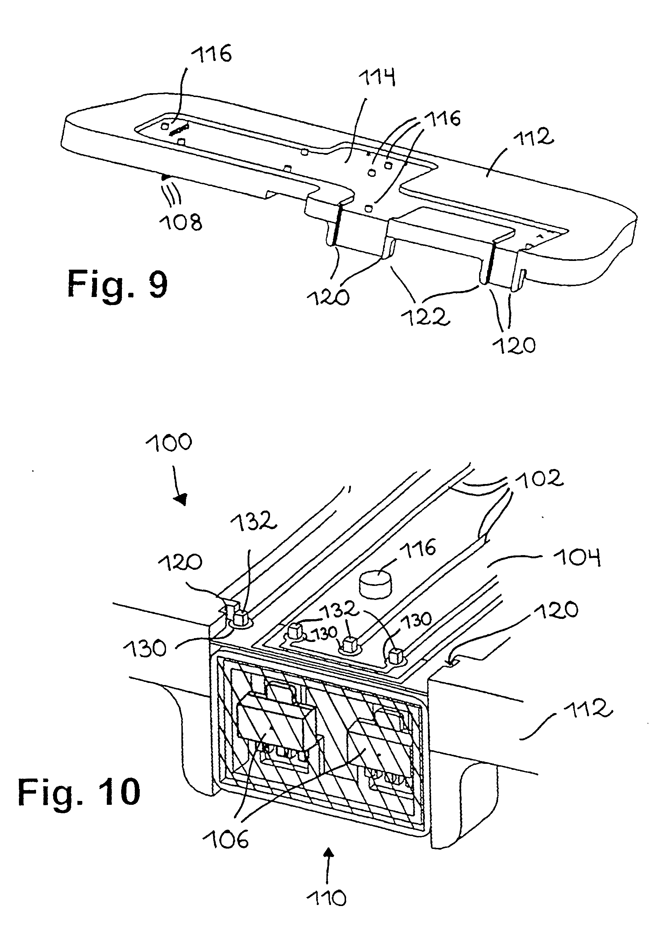

Das in dem zweiten Verfahren zum Einsatz kommende Trägergehäuse 112 ist in Figur 9 dargestellt. Es wird durch Umspritzen der elektrischen Kontaktelemente 108 hergestellt. Während des Umspritzens wurden die Ausnehmung 114, die sich vom Boden der Ausnehmung 114 weg erstreckenden Verbindungsvorsprünge 116, die Verbindungstaschen 122 sowie die darin vorgesehenen Aufnahmenuten 120 ausgeformt.

Das Trägergehäuse 112 gemäß Figur 9 befindet sich in dem Zustand nach Ausführung des Schrittes [2b].

Es sei bemerkt, daß die beiden Schritte [2a] und [2b] gleichzeitig ausgeführt werden.

Den Zustand nach Ausführen des Schrittes [2c] zeigt der Ausschnitt aus dem mit der Leiterfolie 104 verbundenen Trägergehäuse 112 gemäß Figur 10.

Diese Figur macht insbesondere die Art der elektrischen Verbindung zwischen den elektrischen Leiterbahnen 102 und dem Bauelemente-Nest 110 deutlich. Einigen der Leiterbahnen 110 sind zu diesem Zweck Öffnungen 130 zugeordnet, die als die flexible Leiterfolie 104 durchsetzende Löcher ausgebildet sind. Das Innere jeder der Öffnungen 130 ist mit einem elektrisch leitenden Material beschichtet. Die Öffnungen 130 werden von Stanzgitteranschlüssen 132 der Bauelemente-Nester 110 durchgriffen. Die Stanzgitteranschlüsse 132 entsprechen den Durchtrennungsstellen 129 des Stanzgitters 128. Wie aus oben Gesagtem deutlich wird, sind sie mit dem elektrischen Bauelement 106 des jeweiligen Bauelemente-Nestes 110 elektrisch verbunden. Sie durchgreifen die Öffnungen 130 und sind mit diesen verlötet, verschweißt oder leitfähig verklebt. Sie sind daher ebenfalls mit den jeweils zugeordneten elektrischen Leiterbahnen 102 elektrisch verbunden. Es besteht mithin eine durchgehende elektrische Verbindung zwischen bestimmten Leiterbahnen 102 und den Bauelementen 106 der Bauelemente-Nester 110.

Die Figur 10 zeigt den Zustand der Leiterfolie-Trägergehäuse-Einheit 100 nach Ausführung des Schrittes [2c], das heißt, die Leiterfolie 104 und das Bauelemente-Nest 110 sind elektrisch verbunden, und die Leiterfolie 104, das Bauelelemente-Nest 110 und das Trägergehäuse 112 sind mechanisch verbunden.

Die Figuren 6, 7, 8, 11 und 12 stellen schließlich die Herstellung einer Leiterfolie-Trägergehäuse-Einheit 100 nach dem dritten Verfahren dar.

Die Herstellung der Bauelemente-Nester 110 gemäß Schritt [3a] des dritten Verfahrens entspricht dem Schritt [2a] des erfindungsgemäßen zweiten Verfahrens und ist daher unter Bezugnahme auf die Figuren 6 bis 8 bereits erläutert worden.

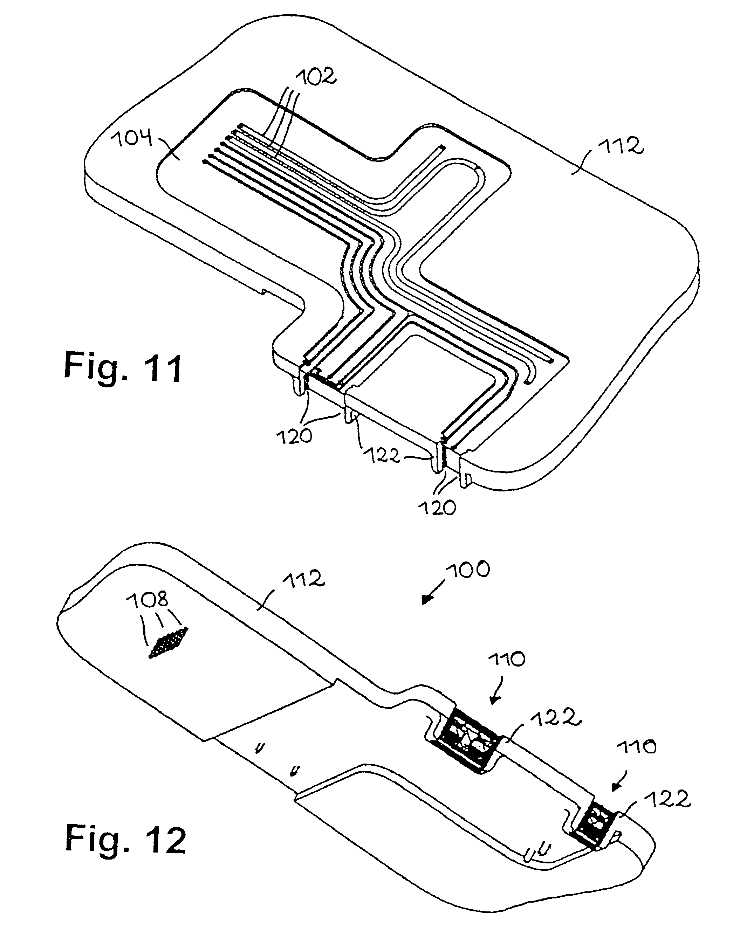

Die Figur 11 zeigt eine Leiterfolie 104 und ein Trägergehäuse 112 nach einem Schritt [3b] des dritten Verfahrens. Das Trägergehäuse 112 ist durch Hinterspritzen der Leiterfolie 104 hergestellt worden, das heißt, die Verbindung zwischen der Leiterfolie 104 und dem Trägergehäuse 112 ist durch ein Anhaften ersterer an letzterem bewirkt. Insofern sind an dem Trägergehäuse 112 keine Verbindungsvorsprünge 116 und an der Leiterfolie 104 keine Verbindungsöffnungen 118 ausgebildet.

Die Schritte [3a] und [3b] können wie die Schritte [2a] und [2b] gleichzeitig ausgeführt werden.

In Figur 12 schließlich ist der Zustand nach Ausführung des Schrittes [3c] dargestellt, das heißt die elektrischen Kontaktelemente 108 und die Bauelemente-Nester 110 sind mit dem Trägergehäuse 112 mechanisch und mit der Leiterfolie 104 elektrisch verbunden worden.

## Patentansprüche

1. Verfahren zur Herstellung einer Leiterfolie-Trägergehäuse-Einheit (100) aus einer elektrische Leiterbahnen (102) aufweisenden flexiblen Leiterfolie (104), mindestens einem elektrischen Bauelement (106), mindestens einem elektrischen Kontaktelement (108), mindestens einem Bauelemente-Nest (110) und einem Trägergehäuse (112), **gekennzeichnet durch** die nachstehenden Schritte:
[1a] mechanisches und elektrisches Verbinden der Leiterfolie (104) mit dem elektrischen Bauelement (106) und dem elektrischen Kontaktelement (108),
[1b] Herstellen mindestens eines offenen Bauelemente-Nestes (110) um mindestens eines der elektrischen Bauelemente (106) herum **durch** Spritzen oder Ausgießen,
[1c] Verschließen der offenen Bauelemente-Nester (110) **durch** Spritzen oder Ausgießen und
[1d] mechanisches Verbinden der Gesamtfäche der Leiterfolie (104), und der verschlossenen Bauelemente-Nester (110), mit dem Trägergehäuse (112).

2. Verfahren nach Anspruch 1, **dadurch gekennzeichnet, daß** das mechanische und elektrische Verbinden in dem Schritt [1a] ein Löten oder Verschweißen ist.

3. Verfahren nach einem der Ansprüche 1 oder 2, **dadurch gekennzeichnet, daß** das Verschließen der Bauelemente-Nester (110) in dem Schritt [1c] derart erfolgt, daß die in den Bauelemente-Nestern (110) enthaltenen Bauelemente (106) vollkommen oder teilweise von Spritzguß umgeben sind.

4. Verfahren nach einem der Ansprüche 1 bis 3, **dadurch gekennzeichnet, daß** das Verschließen der Bauelemente-Nester (110) in dem Schritt [1c] derart erfolgt, daß die in den Bauelemente-Nestern (110) enthaltenen Bauelemente teilweise von Spritzguß umgeben sind und in einem nach dem Schritt [1d] erfolgenden weiteren Schritt die Bauelemente-Nester (110) vollkommen ausgegossen werden.

5. Verfahren zur Herstellung einer Leiterfolie-Trägergehäuse-Einheit (100) aus einer elektrische Leiterbahnen (102) aufweisenden flexiblen Leiterfolie (104), mindestens einem elektrischen Bauelement (106), mindestens einem elektrischen Kontaktelement (108), mindestens einem Bauelemente-Nest (110) und einem Trägergehäuse (112), **gekennzeichnet durch** die nachstehenden Schritte:
[2a] Herstellen der Bauelemente-Nester (110),
[2b] Herstellen des Trägergehäuses (112) **durch** ein Umspritzen oder Ausgießen des Kontaktelementes (108)
[2c] Mechanisches und elektrisches Verbinden der Leiterfolie (104) und des Bauelemente-Nestes (110) sowie mechanisches Verbinden der Beiden mit dem Trägergehäuse (112), und elektrisches Verbinden der Leiterfolie mit den Kontaktelementen (108).

6. Verfahren zur Herstellung einer Leiterfolie-Trägergehäuse-Einheit (100) aus einer elektrische Leiterbahnen (102) aufweisenden flexiblen Leiterfolie (104), mindestens einem elektrischen Bauelement (106), mindestens einem elektrischen Kontaktelement (108), mindestens einem Bauelemente-Nest (110) und einem Trägergehäuse (112), **gekennzeichnet durch** die nachstehenden Schritte:
[3a] Herstellen der Bauelemente-Nester (110),
[3b] Herstellen des Trägergehäuses (112) **durch** Hinterspritzen oder Ausgießen der Leiterfolie (104)
[3c] Mechanisches Verbinden des Trägergehäuses (112), des Kontaktelementes (108) und der Bauelemente-Nester (110) sowie elektrisches Verbinden der Leiterfolie mit den Bauelement-Nestern (110) und den Kontaktelementen (108).

7. Verfahren nach Anspruch 5 oder 6, **dadurch gekennzeichnet, daß** das Herstellen des Bauelemente-Nestes (110) in dem Schritt [2a, 3a] die nachstehenden Schritte umfaßt: [A] Herstellen eines eine Vielzahl von formgleichen Abschnitten (126) aufweisenden Stanzgitters (128) durch Stanzen eines aus einem elektrisch leitenden Material bestehenden Bogens, oder Bereitstellen einer Leiterplatte mit einer Vielzahl von formgleichen Abschnitten (126),
[B] Herstellen der Bauelemente-Nester (110) durch Umspritzen oder Ausgießen jedes der formgleichen Abschnitte (126),
[C] mechanisches und elektrisches Verbinden der Bauelemente-Nester (110) mit den elektrischen Bauelementen (106) durch Löten oder Verschweißen (Laserverschweißen) der Bauelemente (106) in die Bauelemente-Nester (110) derart, daß die elektrischen Bauelemente (106) mit dem Stanzgitter (128) oder der Leiterplatte elektrisch leitend verbunden sind,
[D] Verschließen der Bauelemente-Nester (110) durch Ausspritzen oder Ausgießen der Bauelemente-Nester (110) und
[E] Vereinzeln der Bauelemente-Nester (110) durch Zertrennen des Stanzgitters (128).

8. Verfahren nach einem der Ansprüche 5 bis 7, **dadurch gekennzeichnet, daß** die Leiterfolie (104) im Bereich der Leiterbahnen (102) Öffnungen (130) und die Bauelemente-Nester (110) den Öffnungen (130) anzahl- und anordnungsmäßig zugeordnete stiftartige Stanzgitteranschlüsse (132) aufweisen, und daß das elektrische Verbinden in dem Schritt [2c, 3c] ein Einführen der Stanzgitteranschlüsse (132) in die Öffnungen (130), ein Inberührungbringen der Stanzgitteranschlüsse (132) mit den Leiterbahnen (102) und gegebenfalls ein Verlöten, Verschweißen (Laserverschweißen) oder leitfähiges Verkleben der Stanzgitteranschlüsse (132) mit den Leiterbahnen (102) umfaßt.

9. Verfahren nach Ansprüche 1 bis 5, **dadurch gekennzeichnet, daß** das Trägergehäuse (112) eine Ausnehmung (114) aufweist, deren Querschnittsform der Form der Leiterfolie (104) entspricht, und daß das mechanische Verbinden des Trägergehäuses (112) und der Leiterfolie (104) in dem Schritt [1d, 2c, 3c] ein Einlegen der Leiterfolie (104) in die Ausnehmung (114) umfaßt.

10. Verfahren nach Ansprüche 1 bis 5, **dadurch gekennzeichnet, daß** das Trägergehäuse (112) Verbindungsvorsprünge (116) und die Leiterfolie (104) den Verbindungsvorsprüngen (116) anzahl- und anordnungsmäßig zugeordnete Verbindungsöffnungen (118) aufweist, und daß das mechanische Verbinden in dem Schritt [1d, 2c, 3c] ein Einführen der Verbindungsvorsprünge (116) in die jeweils zugeordneten Verbindungsöffnungen (118) und ein anschließendes Verstemmen der Verbindungsvorsprünge (116) umfaßt.

11. Verfahren nach einem der vorhergehenden Ansprüche, **dadurch gekennzeichnet, daß** das Trägergehäuse (112) mit Aufnahmenuten (120) versehene Verbindungstaschen (122) und die Bauelemente-Nester (110) den Aufnahmenuten (120) anzahl- und anordnungsmäßig zugeordnete Eingriffskanten (124) aufweisen, und daß das mechanische Verbinden in dem Schritt [1d, 2c, 3c] ein Einführen der Eingriffskanten (124) in die Aufnahmenuten (120) bis zu einer vollständigen Aufnahme der Bauelemente-Nester (110) in den Verbindungstaschen (122) umfaßt.

12. Verfahren nach einem der vorhergehenden Ansprüche, **dadurch gekennzeichnet, daß** die Leiterbahnen (102) aus Kupfer gefertigt sind.

13. Verfahren nach einem der vorhergehenden Ansprüche, **dadurch gekennzeichnet, daß** die Bauelemente-Nester (110) und das Trägergehäuse (112) aus Kunststoff bestehen.

## Claims

1. A method for manufacturing a conductive foil/carrier housing unit (100) from a flexible conductive foil (104) incorporating electrically conductive tracks (102), at least one electrical component (106), at least one electrical contact element (108), at least one component housing (110) and a carrier housing (112), **characterised by** the following steps:
[1a] mechanically and electrically connecting the conductive foil (104) to the electrical component (106) and the electrical contact element (108),
[1b] manufacturing at least one open component housing (110) around at least one of the electrical components (106) by injection-molding or casting,
[1c] sealing the open component housings (110) by injection-molding or casting, and
[1d] mechanically connecting the total area of the conductive foil (104), and the sealed component housings (110), with the carrier housing (112).

2. The method according to claim 1, **characterised in that** the mechanical and electrical connection according to step [1a] is soldering or welding.

3. The method according to one of the claims 1 or 2, **characterised in that** the sealing of the component housings (110) according to step [1c] is performed in such a way that the components (106) contained in the component housings (110) are totally or partially surrounded by injection-molding.

4. The method according to one of the claims 1 to 3, **characterised in that** the sealing of the component housings (110) according to step [1c] is performed in such a way that the components contained in the component housings (110) are partially surrounded by injection-molding and that the component housings (110) are totally in-filled in a further step performed after step [1d].

5. A method for manufacturing a conductive foil/carrier housing unit (100) from a flexible conductive foil (104) incorporating electrically conductive tracks (102), at least one electrical component (106), at least one electrical contact element (108), at least one component housing (110) and a carrier housing (112), **characterised by** the following steps:
[2a] manufacturing the component housings (110),
[2b] manufacturing the carrier housing (112) by injection-molding around the contact element (108) or casting the contact element (108),
[2c] mechanically and electrically connecting the conductive foil (104) and the component housing (110) as well as mechanically connecting both of them to the carrier housing (112), and electrically connecting the conductive foil to the contact elements (108).

6. A method for manufacturing a conductive foil/carrier housing unit (100) from a flexible conductive foil (104) incorporating electrically conductive tracks (102), at least one electrical component (106), at least one electrical contact element (108), at least one component housing (110) and a carrier housing (112), **characterised by** the following steps:
[3a] manufacturing the component housings (110),
[3b] manufacturing the carrier housing (112) by reverse side injection-molding around the conductive foil (104) or casting the conductive foil (104),
[3c] mechanically connecting the carrier housing (112), the contact element (108) and the component housings (110) as well as electrically connecting the conductive foil to the component housings (110) and the contact elements (108).

7. The method according to claim 5 or 6, **characterised in that** the manufacturing of the component housing (110) according to step [2a, 3a] comprises the following steps:
[A] manufacturing a punched lattice (128) comprising a plurality of structurally identical portions (126) by punching a sheet consisting of electrically conductive material, or providing a circuit board having a plurality of structurally identical portions (126),
[B] manufacturing the component housings (110) by injection-molding around or casting each of the structurally identical portions (126),
[C] mechanically and electrically connecting the component housings (110) to the electrical components (106) by soldering or welding (laser welding) the components (106) within the component housings (110), such that the electrical components (106) are conductively connected to the punched lattice (128) or the circuit board,
[D] sealing the component housings (110) by injection-molding or casting the component housings (110), and
[E] separating the component housings (110) by cutting the punched lattice (128).

8. The method according to one of the claims 5 to 7, **characterised in that** the conductive foil (104) has openings (130) in the area of the conductive tracks (102), and the component housings (110) have pin like punched lattice connecting portions (132) assigned in number and arrangement to said openings (130), and that electrically connecting according to step [2c, 3c] comprises introducing the punched lattice connecting portions (132) into the openings (130), generating a contact between the punched lattice connecting portions (132) and the conductive tracks (102) and, if necessary, soldering, welding (laser welding) or conductively glueing the punched lattice connecting portions (132) to the conductive tracks (102).

9. The method according to claims 1 to 5, **characterised in that** the carrier housing (112) has a recess (114), the cross section of which corresponds to the shape of the conductive foil (104), and that mechanically connecting the carrier housing (112) to the conductive foil (104) according to step [1d, 2c, 3c] comprises introducing the conductive foil (104) into the recess (114).

10. The method according to claims 1 to 5, **characterised in that** the carrier housing (112) has connecting protrusions (116) and the conductive foil (104) has connecting openings (118) assigned in number and arrangement to the connecting protrusions (116), and that mechanically connecting according to step [1d, 2c, 3c] comprises introducing the connecting protrusions (116) into the respectively assigned connecting openings (118), and subsequent pressure deforming the connecting protrusions (116).

11. The method according to any one of the preceding claims, **characterised in that** the carrier housing (112) comprises connecting pockets (122) having receiving grooves (120), and the component housings (110) comprise engaging edges (124) assigned in number and arrangement to the receiving grooves (120), and that mechanically connecting according to step [1d, 2c, 3c] comprises introducing the engaging edges (124) into the receiving grooves (120) until the component housings (110) are completely received within the connecting pockets (122).

12. The method according to any one of the preceding claims, **characterised in that** the conductive tracks (102) are made of copper.

13. The method according to any one of the preceding claims, **characterised in that** the component housings (110) and the carrier housing (112) are made of plastic.

## Revendications

1. Procédé de fabrication d'une unité d'enceinte de support de feuille conductrice (100) composée d'une feuille conductrice souple (104) présentant des circuits conducteurs électriques (102), d'au moins un composant électrique (106), d'au moins une pièce de contact électrique (108), d'au moins un nid de composants (110) et d'une enceinte de support (112), **caractérisé par** les étapes suivantes :
[1a] Connexion mécanique et électrique de la feuille conductrice (104) avec le composant électrique (106) et avec la pièce de contact électrique (108),
[1b] Fabrication d'au moins un nid de composants ouvert (110) autour d'au moins un des composants électriques (106) par moulage par injection ou garnissage,
[1c] Scellement des nids de composants ouverts (110) par moulage par injection ou garnissage et
[1d] Connexion mécanique de l'intégralité de la surface de la feuille conductrice (104), et des nids de composants scellés (110), avec l'enceinte de support (112).

2. Procédé selon la revendication 1, **caractérisé en ce que** la connexion mécanique et électrique à l'étape [1a] est un brasage ou une soudure.

3. Procédé selon l'une quelconque des revendications 1 ou 2, **caractérisé en ce que** le scellement des nids de composants (110) à l'étape [1c] s'effectue de manière à ce que les composants (106) contenus dans les nids de composants (110) soient intégralement ou partiellement entourés de matière de moulage injectée.

4. Procédé selon l'une quelconque des revendications 1 à 3, **caractérisé en ce que** le scellement des nids de composants (110) à l'étape [1c] s'effectue de manière à ce que les composants contenus dans les nids de composants (110) soient partiellement entourés de matière de moulage injectée et à ce que les nids de composants (110) soient intégralement garnis dans une autre étape ayant lieu après l'étape [1d].

5. Procédé de fabrication d'une unité d'enceinte de support de feuille conductrice (100) composée d'une feuille conductrice souple (104) présentant des circuits conducteurs électriques (102), d'au moins un composant électrique (106), d'au moins une pièce de contact électrique (108), d'au moins un nid de composants (110) et d'une enceinte de support (112), **caractérisé par** les étapes suivantes :
[2a] Fabrication des nids de composants (110),
[2b] Fabrication de l'enceinte de support (112) par un surmoulage ou un garnissage de la pièce de contact (108), [2c] Connexion mécanique et électrique de la feuille conductrice (104) et du nid de composants (110), ainsi que connexion mécanique des deux avec l'enceinte de support (112), et connexion électrique de la feuille conductrice avec les pièces de contact (108).

6. Procédé de fabrication d'une unité d'enceinte de support de feuille conductrice (100) composée d'une feuille conductrice souple (104) présentant des circuits conducteurs électriques (102), d'au moins un composant électrique (106), d'au moins une pièce de contact électrique (108), d'au moins un nid de composants (110) et d'une enceinte de support (112), **caractérisé par** les étapes suivantes :
[3a] Fabrication des nids de composants (110),
[3b] Fabrication de l'enceinte de support (112) par injection ou garnissage de la feuille conductrice (104),
[3c] Connexion mécanique de l'enceinte de support (112), de la pièce de contact (108) et des nids de composants (110), ainsi que connexion électrique de la feuille conductrice avec les nids de composants (110) et avec les pièces de contact (108).

7. Procédé selon l'une quelconque des revendications 5 ou 6, **caractérisé en ce que** la fabrication du nid de composants (110) à l'étape [2a, 3a] comprend les étapes suivantes : [A] Fabrication d'une grille estampée (128) présentant une pluralité de sections de même forme (126) par découpage d'une courbure se composant d'un matériau conducteur électrique, ou mise à disposition d'une plaquette de circuits imprimés avec une pluralité de sections de même forme (126),
[B] Fabrication des nids de composants (110) par surmoulage ou garnissage de chacune des sections de même forme (126),
[C] Connexion mécanique et électrique des nids de composants (110) avec les composants électriques (106) par brasage ou soudage (soudage au laser) des composants (106) dans les nids de composants (110) de telle manière que les composants électriques (106) sont connectés en conduction électrique avec la grille estampée (128) ou avec la plaquette de circuits imprimés,
[D] Scellement des nids de composants (110) par injection ou garnissage des nids de composants (110) et
[E] Séparation des nids de composants (110) par démontage de la grille estampée (128).

8. Procédé selon l'une quelconque des revendications 5 à 7, **caractérisé en ce que** la feuille conductrice (104) présente des ouvertures (130) dans la zone des circuits conducteurs (102) et les nids de composants (110) présentent des bornes de la grille estampée (132) de type tige affectées aux ouvertures (130) conformément au nombre et à l'agencement, et **en ce que** la connexion électrique à l'étape [2c, 3c] comprend une introduction des bornes de la grille estampée (132) dans les ouvertures (130), une mise en contact des bornes de la grille estampée (132) avec les circuits conducteurs (102) et, le cas échéant, un brasage, un soudage (soudage au laser) ou un collage conducteur des bornes de la grille estampée (132) avec les circuits conducteurs (102).

9. Procédé selon l'une quelconque des revendications 1 à 5, **caractérisé en ce que** l'enceinte de support (112) présente un évidement (114) dont la forme de la section transversale correspond à la forme de la feuille conductrice (104), et **en ce que** la connexion mécanique de l'enceinte de support (112) et de la feuille conductrice (104) à l'étape [1d, 2c, 3c] comprend une mise en place de la feuille conductrice (104) dans l'évidement (114).

10. Procédé selon l'une quelconque des revendications 1 à 5, **caractérisé en ce que** l'enceinte de support (112) présente des saillies de connexion (116) et la feuille conductrice (104) présente des ouvertures de connexion (118) affectées aux saillies de connexion (116) en correspondance et en nombre, et **en ce que** la connexion mécanique à l'étape [1d, 2c, 3c] comprend une insertion des saillies de connexion (116) dans les ouvertures de connexion (118) en correspondance à chaque fois et un matage consécutif des saillies de connexion (116).

11. Procédé selon l'une quelconque des revendications précédentes, **caractérisé en ce que** l'enceinte de support (112) présente des poches de connexion (122) munies de rainures de réception (120) et les nids de composants (110) présentent des arêtes d'engrènement (124) aux rainures de réception (120) en correspondance et en nombre, et **en ce que** la connexion mécanique à l'étape [1d, 2c, 3c] comprend une insertion des arêtes d'engrènement (124) dans les rainures de réception (120) jusqu'à une admission intégrale des nids de composants (110) dans les poches de connexion (122).

12. Procédé selon l'une quelconque des revendications précédentes, **caractérisé en ce que** les circuits conducteurs (102) sont fabriqués en cuivre.

13. Procédé selon l'une quelconque des revendications précédentes, **caractérisé en ce que** les nids de composants (110) et l'enceinte de support (112) se composent de plastique.
